Europäisches Patentamt

European Patent Office

Office européen des brevets

(11) Publication number: **0 458 517 A1**

# EUROPEAN PATENT APPLICATION

(21) Application number: **91304340.2**

(22) Date of filing: **15.05.91**

(51) Int. Cl.⁵: **H05K 9/00**

(30) Priority: **16.05.90 GB 9011017**

(43) Date of publication of application:
**27.11.91 Bulletin 91/48**

(84) Designated Contracting States:
**DE FR SE**

(71) Applicant: **GPT LIMITED**
**New Century Park, P.O. Box 53**
**Coventry CV3 1HJ (GB)**

(72) Inventor: **Elliott, Donald Charles**
**20 Spinney Hill**
**Warwick, Warwickshire CV34 5ST (GB)**

(74) Representative: **MacKenzie, Ian Alastair**
**Robert**
**The General Electric Company, p.l.c. Central**
**Patent Department Wembley Office Hirst**
**Research Center East Lane**
**Wembley Middlesex HA9 7PP (GB)**

(54) **A seam clip.**

(57)   The invention concerns a seam clip made from electrically conductive material, the clip being substantially formed in a U-shaped section having two limbs (3, 4) forming a channel therebetween enabling the clip to be accommodated over abutting edges of panels which form an electrical equipment enclosure. The clip is characterised in that each limb (3, 4) is provided with a plurality of holes (2), said holes (2) having edges protruding into the channel, so that in use, the edges of said holes (2) make good electrical contact with the abutting edges of the panels, and thereby reduce electromagnetic (EM) emission from the enclosure.

EP 0 458 517 A1

Fig.2

The present invention relates to a seam clip for use on enclosures which house electronic equipment.

Enclosures which house electronic equipment require to be constructed in such a manner as to prevent electro magnetic (EM) emissions from the equipment housed within when functioning, from exceeding a certain level when measured at a specified distance from the equipment.

Ideally this is achieved by providing a seamless box so that electrical continuity is constant over all sides and around all edges and corners of the box. In reality an enclosure will have to incorporate seams and joints in its construction and these should be designed so they do not present a significant change in electrical continuity across the joint.

A known way of achieving this is to make connections at close regular intervals using threaded fasteners, rivets, spot welds and the like. Assuming the individual fastenings make good conductive joints in their near vicinity, there is a possibility that there could still be poor continuity in the interval between the fixings, forming a series of "slot elements" which will allow r.f energy to leak through. The wavelength and hence the frequency of the EM leakage will be a function of the length of the slots.

An object of the present invention is to provide a seam clip providing an alternative means of linking two parts of a screened enclosure. The seam clip may also be used were adjacent parts of the enclosure have a surface paint finish.

According to the present invention there is provided a seam clip made from an electrically conductive material, the clip being substantially formed in a U-shaped section having two limbs forming a channel therebetween enabling the clip to be accommodated over abutting edges of panels which form an electrical equipment enclosure, the clip being provided with a plurality of holes in each limb of the clip, said holes having edges protruding into the channel, so that in use, the edges of said holes make good electrical contact with the abutting edges of the panels, and thereby reduce electromagnetic (EM) emissions from the enclosure.

The present invention provides an economic way of reducing EM emissions from electrical equipment. Furthermore if the distance between the holes is carefully selected the clip will give satisfactory EM shielding at a desired frequency.

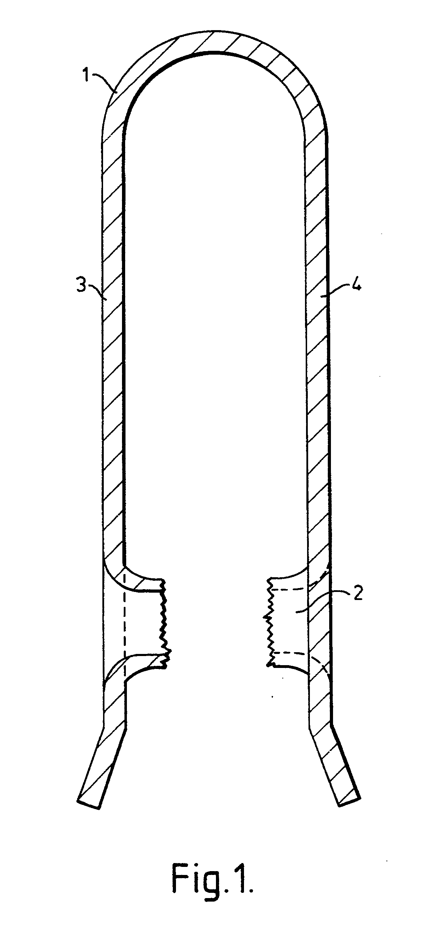

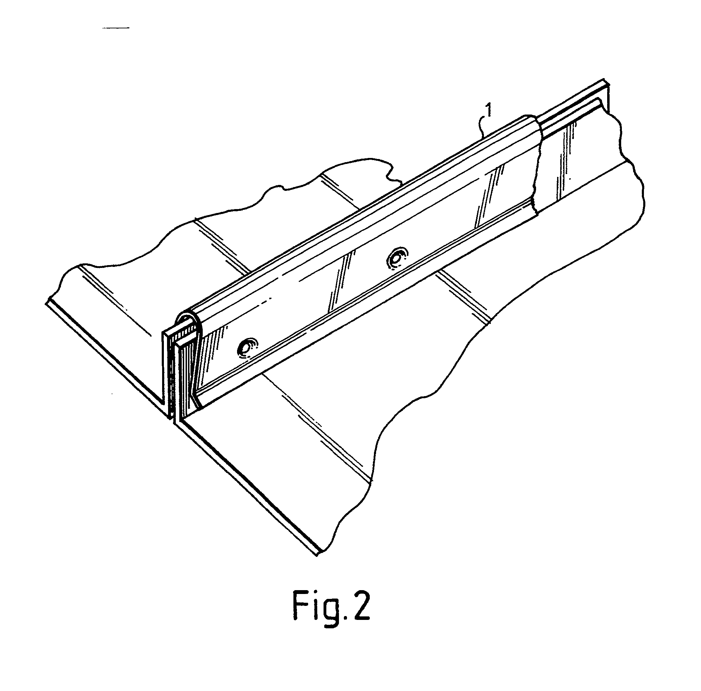

An embodiment of the present invention will now be described with reference to the accompanying drawings wherein Figure 1 shows an end elevation of a seam clip in part cross section, and Figure 2 shows a perspective view of a seam clip accommodated upon the abutting edges of the two panels which form part of an enclosure for electrical equipment.

Referring to the drawings, the seam clip 1 consists of a length of folded stainless steel forming substantially a U-shaped section. In the present example the clip is made of stainless steel having a width of 0.5 mm and each clip is approximately 600 mm in length. A plurality of holes 2 are extruded into the seam clip in each limb 3 4 of the clip. The holes are positioned in close proximity to the lower edge of each limb and the centre of the hole 2 is approximately 5 mm from the edge of limb. The extruded holes 2 protrude inwardly towards the opposite limb. The holes have their inwardly protruding edges left as ragged as possible to facilitate good electrical contact with the panels constituting the equipment enclosure.

The hole are staggered on opposite sides of each limb and appear at 30 mm intervals. As this is one tenth of the wavelength of 1,000 MHz, the clip should give satisfactory EM shielding up to that frequency.

The lower edges of each of the limbs are flared outwardly at approximately 40°, and this facilitates easing the seam clip over the edges of adjacent abutting panels. The dimension of the clip is such that it can be used on panel edges 1.6 mm thick with a gap therebetween of between 0 and 1 mm. The clip is pushed over the abutting edges of the panels or hammered over said edges and because the inwardly protruding holes have ragged edges, good electrical contact will be made with the panels even under the circumstances where the panels have a coating of paint thereon.

Referring to Figure 2 a seam clip 1 is shown in position upon two abutting panel edges. It will readily be seen from Figure 2 that by fitting such a clip over said edges the two edges are brought together, and the clip being made of electrically conductive material electrically bridges any gap between the two panels which may be caused by for example, a surface coating of paint on the panels.

The above description has been of one embodiment of the present invention, however, it will readily be appreciated by those skilled in the art that alternative embodiments are possible which fall in the spirit and scope of the present invention will readily be appreciated.

## Claims

1. A seam clip made from electrically conductive material, the clip being substantially formed in a U-shaped section having two limbs (3, 4) forming a channel therebetween enabling the clip to be accommodated over abutting edges of panels which form an electrical equipment enclosure, and being characterised in that each limb (3, 4) is provided with a plurality of holes (2), said holes (2) having edges protruding into the channel, so that in use, the edges of said holes (2) make good electrical contact with the abutting edges of the panels, and thereby reduce electromagnetic (EM) emission from the enclosure.

2. A seam clip as claimed in Claim 1, and further characterised in that the edges of the holes (2) are ragged.

3. A seam clip as claimed in Claim 1 or Claim 2 and further characterised in that the holes (2) in each limb (3, 4) are spaced apart by approximately 30 mm.

4. A seam clip as claimed in any one of the preceding Claims and further characterised in that the holes (2) of one limb (3, 4) are staggered with respect to the holes in the other limb (3, 4).

5. A seam clip as claimed in any one of the preceding Claims and further characterised in that each limb (3, 4) has its end outwardly flared.

6. A seam clip as claimed in any one of the preceding Claims and characterised in that the clip is approximately 600 mm, in length, and the limbs (3, 4) are approximately 4,5 mm apart.

# Fig.1.

EP 0 458 517 A1

Fig.2

6

**European Patent Office**

## EUROPEAN SEARCH REPORT

Application Number

EP 91 30 4340

### DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | US-A-3 340 587 (BEYER) <br> * Column 1, lines 16-18; column 4, lines 74-75; column 5, lines 1-13; figures 4,5 * | 1 | H 05 K 9/00 |
| A | EP-A-0 113 852 (SIEMENS) <br> * Claim; figure 2 * | 1 | |
| A | FR-A-2 205 956 (RAPID S.A.) <br> * Claim 1; figures 1,2 * | 1 | |

**TECHNICAL FIELDS SEARCHED (Int. Cl.5)**

H 05 K
F 16 B

The present search report has been drawn up for all claims

| Place of search | Date of completion of the search | Examiner |
|---|---|---|
| THE HAGUE | 22-08-1991 | RUBENOWITZ |

EPO FORM 1503 03.82 (P0401)